# FASCICULE DE BREVET EUROPEEN

(11) **EP 3 132 273 B1**
(45) Date de publication et mention de la délivrance du brevet: **06.06.2018**
(21) Numéro de dépôt: 15718186.8
(22) Date de dépôt: 16.04.2015
(51) Int. Cl.: H01M 10/42, G01R 31/36

(54) **PROCEDE D'ESTIMATION DE L'ETAT DE SANTE D'UNE BATTERIE**
VERFAHREN ZUR SCHÄTZUNG DES INTAKTHEITSSTATUS EINER BATTERIE
METHOD FOR ESTIMATING THE STATE OF HEALTH OF A BATTERY

(30) Priorité: 16.04.2014 FR 1453408
(43) Date de publication de la demande: 22.02.2017
(73) Titulaire: Renault s.a.s, 92100 Boulogne-Billancourt (FR)
(72) Inventeur: MONTARU, Maxime, F-15170 Joursac (FR)
(74) Mandataire: Novaimo
(86) Numéro de dépôt international: PCT/EP2015/058252
(87) Numéro de publication internationale: WO 2015/158813

(56) Documents cités:
- FR-A1- 2 955 670
- US-A1- 2002 030 494
- US-A1- 2012 035 873
- US-A1- 2013 166 234

## Description

L'invention concerne un procédé d'estimation de l'état de santé d'une batterie. Elle concerne aussi un procédé de calibration d'une batterie, et un procédé de gestion d'une batterie. Enfin, elle concerne aussi un système de gestion de batterie mettant en oeuvre ce procédé d'estimation de l'état de santé d'une batterie.

La gestion des batteries de l'état de la technique fait appel à un indicateur représentatif du vieillissement d'une batterie, souvent appelé par sa dénomination anglo-saxonne de « State Of Health » pour état de santé, ou plus simplement SOH. Cet indicateur, parfois aussi appelé état de vie, est usuellement exprimé en pourcentage de la capacité initiale à l'état neuf de la batterie, capacité mesurée dans cet état initial ou fournie par le fabricant de la batterie. Le SOH est couramment utilisé dans le diagnostic d'une batterie. Son évaluation est importante pour une bonne maîtrise du fonctionnement de la batterie, ainsi que pour gérer au mieux sa fin de vie. Le document US 2002/030494 A1 (ARAKI KAZUHIRO 14.03.2002) divulgue un procédé de calibration d'un batterie permettant de mémoriser un coefficient de vieillissement de la batterie.

Selon une première approche, la valeur réelle du SOH est mesurée en mettant en oeuvre un test de capacité, consistant en une charge puis une décharge successive complètes de la batterie, dans des conditions choisies de température et de courant. Durant cette décharge, la quantité de charges restituée est mesurée, ce qui permet d'en déduire la capacité réelle de la batterie, et donc son SOH. L'avantage de cette méthode est d'obtenir la valeur réelle du SOH, puisqu'elle repose sur une mesure de la réalité. Toutefois, ses inconvénients sont qu'elle nécessite une durée importante, consomme de l'énergie, et nécessite une intervention sur la batterie qui est parfois incompatible avec son utilisation normale, c'est-à-dire de fourniture d'énergie pour la mise en oeuvre d'une certaine application concrète : elle nécessite alors une pause de cette application, pour la mise en oeuvre du test de la batterie. Pour cette dernière raison, cette première approche est considérée intrusive puisqu'elle nécessite généralement l'arrêt de l'utilisation normale de la batterie.

Pour pallier aux inconvénients de la mesure du SOH réel, d'autres approches moins intrusives existent, qui reposent sur son estimation. A titre d'exemple, une méthode usuelle pour estimer le SOH consiste à suivre l'évolution de la résistance de la batterie, ou par extension suivre un ou plusieurs paramètres d'impédance de la batterie. L'usure d'une batterie s'accompagne en effet généralement d'une évolution de ces paramètres. L'inconvénient de cette méthode est de ne pas mesurer directement la perte de capacité de la batterie, mais de l'estimer à partir de l'évolution d'un paramètre différent, tout en étant très dépendante de la mesure de la température. Or, l'évolution des pertes de capacité et des augmentations de résistance, ou d'impédances, ne suivent pas des lois généralisables pour toutes les batteries, ni pour toutes les conditions de vieillissement des batteries. Ainsi, il existe des situations pratiques pour lesquelles l'augmentation de la résistance d'une batterie est parfois négligeable alors que la batterie subit une perte de capacité importante, et inversement. Cette méthode d'estimation reste donc insuffisamment fiable, et souvent complexe car elle nécessite des calculs complémentaires reposant par exemple sur un apprentissage préalable pour tenter de pallier à ses défaillances.

Ainsi, un objet général de l'invention est de proposer une solution d'estimation du SOH d'une batterie qui ne comprend pas tout ou partie des inconvénients de l'état de la technique.

Plus précisément, un objet de l'invention est de proposer une solution d'estimation du SOH d'une batterie, fiable, rapide, non intrusive.

A cet effet, l'invention repose sur un procédé de calibration d'une batterie permettant de mémoriser des données de calibration liées à son état de santé, caractérisé en ce qu'il comprend les étapes suivantes :
- détermination d'au moins un état caractéristique de la batterie, intermédiaire entre sa pleine charge et sa pleine décharge, par la détection d'un pic de l'évolution de la dérivée de sa tension à vide pendant une charge ou une décharge de la batterie, ou d'au moins un état caractéristique à sa pleine charge ou sa pleine décharge, ou défini par le passage d'un seuil de tension, respectivement de courant, lors d'une phase de courant imposé, respectivement de tension imposée, pendant une charge ou une décharge de la batterie ;
- définition d'un état de référence de la batterie à partir de cet état caractéristique ;
- mesure des tensions à vide OCVi de la batterie à l'état de référence pour plusieurs états de santé SOHi distincts et mémorisation de ces données de calibration comprenant au moins des couples de valeurs réelles état de santé/tension à vide (SOHi, OCVi) dans une mémoire électronique.

L'étape de détermination d'au moins un état caractéristique de la batterie peut prendre en compte la dérivée de sa tension à vide par rapport à la quantité de charge accumulée par la batterie ou par rapport au temps.

L'état de référence peut être choisi dans une zone stabilisée de la dérivée de la tension à vide à proximité du pic de l'état caractéristique détecté.

L'état de référence peut être défini par un décalage d'une charge fixe Q1 de la charge accumulée par la batterie par rapport à sa charge au niveau du pic détecté.

Le procédé de calibration d'une batterie peut comprendre la répétition des étapes suivantes pour plusieurs états de santé distincts d'au moins une batterie :
- positionnement d'une batterie dans un état de santé SOHi choisi et connu ;
- charge ou décharge de la batterie, mesure et/ou estimation de la dérivée de la tension à vide de la batterie et détection du pic prédéfini de la dérivée ;
- poursuite de la charge ou décharge d'une quantité de charge prédéfinie à partir du pic prédéfini pour atteindre l'état de référence de la batterie, et mesure de sa tension à vide OCVi dans cet état de référence ;
- mémorisation dans une mémoire électronique comprenant les données de calibration du couple de valeurs comprenant la valeur de l'état de santé SOHi et la tension à vide OCVi associée à l'état de référence de la batterie.

Le procédé de calibration d'une batterie peut mettre en oeuvre des phases de charge ou décharge lentes de la batterie pour faciliter la mesure de la tension à vide.

La tension à vide de la batterie peut être obtenue par l'une des étapes suivantes :
- Mesure de la tension aux bornes de la batterie non reliée à une charge après un temps de relaxation supérieur à une heure ; ou
- Mesure de la tension aux bornes de la batterie non reliée à une charge après un temps de relaxation inférieur ou égal à une heure ; ou
- Mesure de la tension aux bornes de la batterie malgré un très faible courant, émis ou reçu par la batterie ; ou
- Mesure de la tension aux bornes de la batterie dans des conditions différentes de la tension à vide théorique et mise en oeuvre d'une correction de la tension mesurée pour estimer la tension à vide ;
- Estimation de la tension à vide de la batterie à partir d'une ou plusieurs grandeur(s) électrique(s) mesurée(s) de la batterie.

Le procédé de calibration d'une batterie peut comprendre une étape de détermination d'une loi entre l'état de santé de la batterie et sa tension à vide dans l'état de référence, notamment par interpolation linéaire et/ou la construction d'un abaque associant une valeur d'état de santé de la batterie à une valeur de tension à vide de la batterie à un état de référence, à partir des couples de valeurs réelles état de santé/tension à vide (SOHi, OCVi).

Le procédé de calibration d'une batterie peut être mis en oeuvre à partir d'au moins une batterie de la famille de batteries à l'état neuf, et à partir de la même batterie dans au moins un état de vieillissement.

L'invention porte aussi sur un procédé d'estimation de l'état de santé d'une batterie, caractérisé en ce qu'il comprend une phase de calibration mettant en oeuvre un procédé de calibration tel que décrit précédemment, et une phase d'estimation de l'état de santé de la batterie comprenant la mesure de sa tension à vide dans l'état de référence et la déduction de l'estimation de son état de santé à partir des données de calibration obtenues dans la phase de calibration et de la tension à vide mesurée.

La seconde phase d'estimation peut comprendre tout ou partie des étapes préalables suivantes, en vue de déterminer son déclenchement :
- Commande de déclenchement suite à une demande d'un utilisateur par l'intermédiaire d'une interface homme machine d'un dispositif dans lequel la batterie est utilisée ou d'un dispositif de charge de la batterie ; et/ou
- Déclenchement automatique selon une fréquence prédéfinie ; et/ou
- Déclenchement automatique lorsque les conditions électriques de la batterie sont favorables ;
- Déclenchement automatique lors d'une phase de charge d'une batterie ;

ET / OU peut comprendre les étapes préalables suivantes :
- Une étape de détection automatique de la situation électrique de la batterie pour détecter l'état caractéristique; ou
- Une étape de modification de la configuration de la batterie pour la positionner à proximité de l'état de référence.

Le procédé d'estimation de l'état de santé d'une batterie peut mettre en oeuvre les étapes suivantes :
- mesure ou estimation de la dérivée de la tension à vide pendant une charge ou décharge de la batterie,
- détection d'un pic de cette dérivée de la tension à vide,
- positionnement de la batterie à son état de référence à partir du pic de la dérivée de la tension à vide, et mesure de la tension à vide de la batterie,
- déduction de l'état de santé de la batterie à partir des données de calibration et de la tension à vide mesurée.

L'invention porte aussi sur un support informatique lisible par une unité de gestion, caractérisé en ce qu'il comprend un programme informatique enregistré comprenant des moyens de codes de programme informatique de mise en oeuvre du procédé d'estimation de l'état de santé d'une batterie tel que décrit précédemment.

L'invention porte aussi sur un dispositif comprenant au moins une batterie et une unité de gestion, caractérisé en ce que l'unité de gestion met en oeuvre un procédé d'estimation de l'état de santé d'au moins une batterie tel que décrit précédemment.

Le dispositif peut être un véhicule automobile ou un objet portable comme un ordinateur, un téléphone, une tablette ou un agenda électronique.

L'invention porte aussi sur un dispositif de calibration d'une batterie, caractérisé en ce qu'il met en oeuvre un procédé de calibration tel que décrit précédemment.

Ces objets, caractéristiques et avantages de la présente invention seront exposés en détail dans la description suivante d'un mode de réalisation particulier fait à titre non-limitatif en relation avec les figures jointes parmi lesquelles :
La figure 1 représente plusieurs courbes d'évolution de la tension à vide OCV d'une batterie en fonction de la charge transmise à la batterie durant une phase de charge pour respectivement plusieurs valeurs d'état de santé SOH de la batterie.
La figure 2 représente plusieurs courbes d'évolution de la dérivée de la fonction représentant la tension à vide OCV d'une batterie par la charge transmise à la batterie durant une phase de charge en fonction de cette charge pour respectivement plusieurs valeurs de SOH de la batterie.
La figure 3 représente les mêmes courbes que celles de la figure 2 mais recalées entre elles.
La figure 4 représente les mêmes courbes que celles de la figure 1 mais recalées selon le recalage défini par la figure 3.
La figure 5 représente la relation entre l'état de santé SOH de la batterie et la tension à vide OCV de la batterie à un état de référence de la batterie défini par le mode de réalisation de l'invention.
La figure 6 représente schématiquement un organigramme d'un procédé d'estimation de l'état de santé d'une batterie selon un mode de réalisation de l'invention.

Le procédé selon l'invention va exploiter la tension à vide d'une batterie, aussi dénommée OCV pour la dénomination anglo-saxonne de « Open Circuit Voltage », qui présente l'avantage d'être indépendante de la température. Cette tension à vide se définit comme la tension mesurée aux bornes de la batterie lorsqu'elle n'est pas utilisée, et après une période de relaxation faisant suite à sa dernière utilisation, durant laquelle la tension à ses bornes évoluent jusqu'à converger vers une valeur stabilisée, qui est la « tension à vide ».

En remarque, cette tension à vide théorique est rarement exploitée telle que définie ci-dessus, car il faudrait un temps de relaxation relativement long, souvent de plusieurs heures, pour atteindre une valeur de tension stabilisée aux bornes de la batterie, assimilable à la tension à vide, ce qui est généralement incompatible avec les exigences d'utilisation d'une batterie.

Pour cette raison, nous étendons la définition de tension à vide à des valeurs s'en approchant légèrement, parfois appelées « pseudo tension à vide », pour des raisons de facilité d'exploitation des solutions associées. Ainsi, le terme de tension à vide sera utilisé par la suite pour intégrer aussi les valeurs proches suivantes de tension aux bornes d'une batterie :
- Une tension à vide mesurée après un temps de relaxation raccourci, pour lequel la tension aux bornes de la batterie ne peut pas être considérée comme ayant convergé vers la valeur théorique de tension à vide ;
- Une tension à vide mesurée malgré un très faible courant, émis ou reçu par la batterie, par exemple dans le cadre d'une phase de charge très lente, comme à C/25, où C serait le régime de charge nominal recommandé ;
- Une tension à vide estimée à partir d'une des mesures de tension dans des conditions différentes de la tension à vide définie ci-dessus, comme dans les deux configurations mentionnées ci-dessus, en appliquant une correction pour tenir compte de cette situation, notamment de la chute de tension due à l'impédance de la batterie ;
- Une tension à vide estimée à partir de toute autre mesure électrique ou estimation électrique de la batterie ;
- Une tension à vide, mesurée ou estimée, par l'une des approches mentionnées ci-dessus, lors d'une phase de charge ou de décharge d'une batterie. On s'aperçoit qu'on n'obtient pas exactement la même valeur de tension à vide aux bornes d'une batterie si cette dernière se trouvait en phase de charge ou de décharge, avec sa relaxation. Il existe donc potentiellement deux valeurs de tension à vide, respectivement de charge et de décharge. Nous considèrerons donc l'une des deux valeurs, ou en variante, une valeur moyenne des tensions à vide de charge et de décharge.

Ainsi, le procédé selon le mode de réalisation de l'invention, qui va être décrit ci-après, peut être mis en oeuvre avec l'une quelconque des approches ci-dessus pour la définition de la tension à vide OCV. Toutefois, il faudra utiliser la même définition de cette tension à vide dans toutes les étapes de ce procédé de calibration et d'estimation du SOH pour obtenir un résultat le plus cohérent et précis possible.

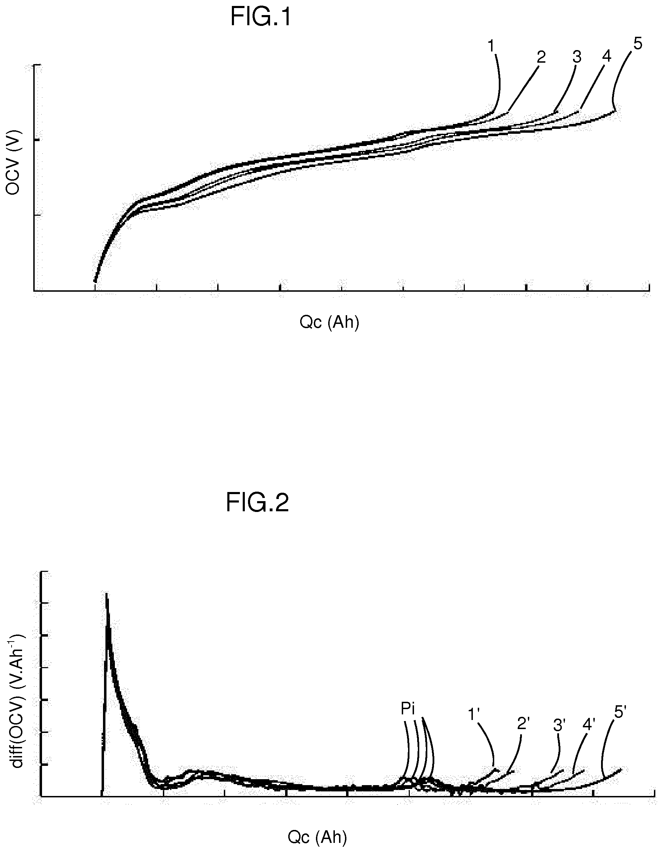

La figure 1 comprend cinq courbes 1 à 5 d'évolution de la tension à vide OCV (en V) d'une batterie en fonction de la quantité de charge Qc (en Ah) accumulée par la batterie durant une phase de charge, obtenues pour respectivement des états de santé SOHi (i variant de 1 à 5) de la batterie respectifs de 73%, 75%, 85%, 89% et 100%. Ces courbes montrent que la valeur de l'état de santé SOH d'une batterie, pour une charge donnée, dépend de sa tension à vide.

A partir des courbes 1 à 5 de cette figure 1, cinq courbes 1' à 5' sont tracées en figure 2, représentant respectivement les valeurs de la dérivée de la fonction de tension à vide en fonction de la quantité de charge, pour respectivement les cinq courbes 1 à 5. Ces courbes comprennent toutes un pic Pi (i variant de 1 à 5). Ces différents pics Pi sont légèrement décalés les uns des autres, c'est-à-dire obtenus pour différents niveaux de quantités de charges Qc de la batterie pour différents états de santé SOH de la batterie. Ces pics représentent localement des maximums de ces dérivées.

Des analyses ont montré que les pics constatés correspondent à un état physique particulier de la batterie, dans lequel survient une transition de phase au niveau de ses deux électrodes. Cet état particulier (ou état caractéristique) se déplace avec le vieillissement de la batterie. Il est facilement détectable par la simple observation des courbes 1' à 5'. Il va servir à définir un état de référence intermédiaire de la batterie pour l'estimation de son état de santé, comme cela va être décrit ci-dessous.

Les conclusions précédentes vont donc être exploitées pour la mise en oeuvre d'une estimation de l'état de santé d'une batterie selon les deux principes suivants :
- Cet état de santé va être déduit de la tension à vide de la batterie ;
- Cet état de santé va être estimé pour un état de charge intermédiaire de la batterie, entre la pleine charge et la pleine décharge.

Un mode de réalisation détaillé de l'invention va maintenant être explicité.

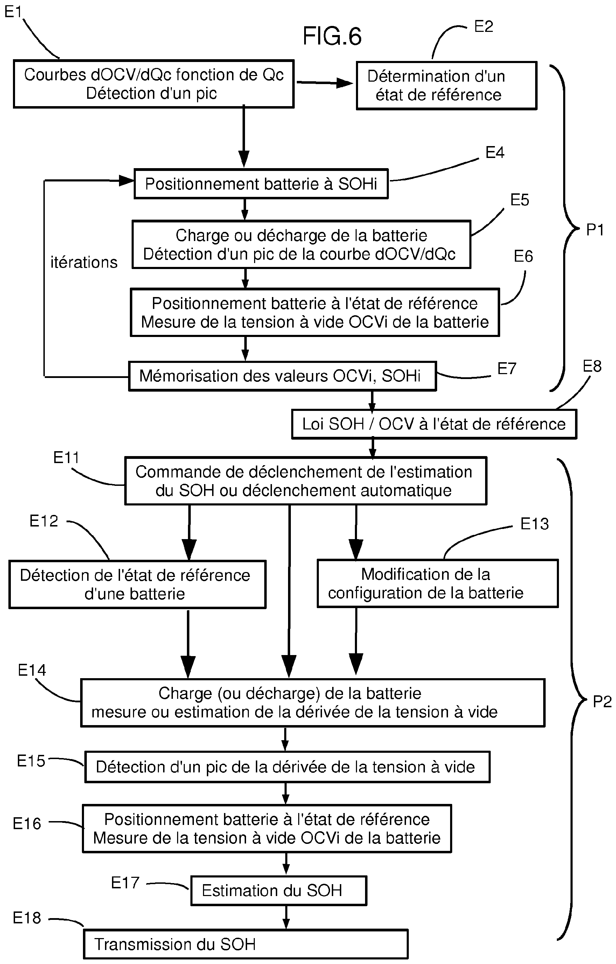

Ce mode de réalisation repose sur un procédé d'estimation de l'état de santé d'une batterie, représenté schématiquement par le diagramme de la figure 6, qui comprend les deux phases suivantes :
- Une première phase préalable P1 repose sur un procédé de calibration permettant de calculer des données de calibration, comprenant des valeurs de référence d'état de santé SOH d'une certaine batterie en fonction de sa tension à vide pour un certain état de référence ;
- Une seconde phase d'estimation P2 du SOH pendant l'utilisation de la batterie, à partir des résultats du procédé de calibration.

En remarque, dans cette première phase de calibration, le SOH d'une batterie utilisée pour la calibration est calculé par une méthode connue et très précise, afin d'établir une calibration précise avec des valeurs réelles de SOH pour atteindre une grande performance lors des futures estimations.

Selon le mode de réalisation, le procédé de calibration comprend d'abord une première étape E1 consistant à rechercher au moins un pic Pi d'une courbe dOCV/dQc en fonction de la quantité de charge Qc d'une batterie. Pour cela, au moins une des courbes 1' à 5' est tracée, en mettant en oeuvre une charge et une mesure de valeurs d'OCV avec une fréquence importante, c'est-à-dire une procédure de test permettant d'obtenir des valeurs d'OCV avec des pas suffisamment fins par rapport aux variations de la courbe dOCV/dQ, pour obtenir la courbe avec précision et s'assurer la bonne détection d'un pic. Lorsque la géométrie du pic sélectionné est identifiée, on choisit une fréquence de mesures d'OCV suffisantes pour détecter le pic, mais pas nécessairement aussi fréquente pour éviter tout alourdissement du procédé par un trop grand nombre de mesures d'OCV. Un second mode de réalisation consisterait à définir un état caractéristique détectable en utilisant la mesure de la tension (respectivement du courant) par le passage d'un seuil de tension (respectivement du courant) à un courant imposé (respectivement une tension) pour une certaine température au cours d'une charge ou d'une décharge. Le reste de la description va être détaillé dans le cadre d'un mode de réalisation associé à la détection d'un pic.

Une deuxième étape E2 consiste à déterminer un état de référence de la batterie à partir du (ou des) pic identifié, qui caractérise un état particulier de la batterie. Cet état de référence n'est de préférence pas choisi au niveau du pic lui-même car, par définition, la valeur de la tension à vide OCV présente une variation plus forte avec la quantité de charge Qc au niveau de ce pic, ce qui représente une zone défavorable. En effet, le procédé d'estimation va être basé sur la mesure de la tension à vide de la batterie à l'état de référence et il est plus favorable que cette valeur soit relativement stable autour de cet état de référence, pour minimiser les erreurs. Pour cette raison, l'état de référence de la batterie est choisi hors du pic, sur une zone pour laquelle la dérivée présente une faible valeur, et donc pour laquelle les valeurs de OCV sont relativement stables. Toutefois, cet état de référence reste aussi proche que possible du pic identifié, afin de ne pas compliquer son identification, qui se fera à partir de la reconnaissance du pic par la suite. Ainsi, l'état de référence est de préférence distinct d'un état caractéristique détecté par un pic, comme explicité ci-dessus.

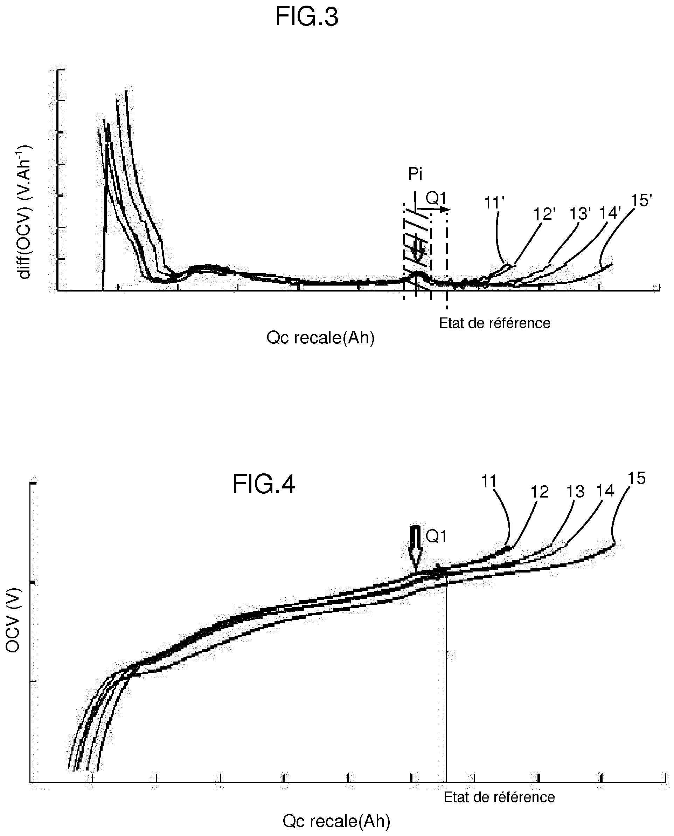

Pour illustrer ce choix de l'état de référence sur l'exemple illustré, une figure 3 est construite sur laquelle cinq courbes 11' à 15' sont tracées, correspondant respectivement aux courbes 1' à 5' de la figure 2, mais décalées pour obtenir la superposition de leurs pics Pi représentant l'état particulier intermédiaire de la batterie. Suite aux explications précédentes, il est choisi de déterminer l'état de référence du procédé de calibration en dehors de la zone hachurée entourant le pic, pour laquelle la valeur de la dérivée est plus élevée. Finalement, dans le mode de réalisation décrit, l'état de référence est défini par une charge Q1 prédéterminée de charge de la batterie à partir d'un pic Pi, qui permet de s'éloigner de la zone non recommandée, tout en restant à proximité. La différence entre un pic Pi et l'état de référence à proximité est de préférence inférieure ou égale à 5 Ah, voire 3 Ah. A titre d'exemple de réalisation, elle est aussi de préférence supérieure ou égale à 2 Ah.

La figure 4 illustre cinq courbes 11 à 15 correspondant respectivement aux courbes 1 à 5 décalées selon le décalage explicité ci-dessus, pour permettre la superposition de leur état de référence.

Les deux étapes précédentes E1, E2 peuvent être mises en oeuvre pour une seule valeur de SOH de la batterie, qui suffit pour la détection d'un pic et le choix d'un état de référence. En variante, la pertinence d'un pic peut être validée par la répétition de ces étapes pour plusieurs états de santé différents de la batterie.

Ensuite, lorsque ces deux étapes préalables ont été réalisées, le procédé met en oeuvre une itération des étapes suivantes (selon le nombre d'états de santé distincts choisi et/ou le nombre de batteries choisi), pour plusieurs états de santé connus d'une batterie :
E4 : positionnement de la batterie dans un état de santé SOHi choisi et connu ;
E5 : charge de la batterie, mesure de la quantité de charge et de la tension à vide, et surtout de la dérivée de la tension à vide par rapport à la charge, et détection du pic prédéfini ;
E6 : poursuite de la charge d'une valeur Q1 à partir du pic identifié pour atteindre l'état de référence de la batterie, et mesure de sa tension à vide ;
E7 : mémorisation dans une mémoire électronique de la valeur du SOH et de la tension à vide OCV associée, ces deux valeurs étant obtenues à l'état de référence de la batterie. Le couple (OCV, SOH) forme une donnée de référence, une donnée de calibration de la batterie.

En remarque, lors de la mise en oeuvre de l'étape E5, l'état de départ de la batterie peut être son état totalement déchargé, ce qui permet de mesurer la charge globale de la batterie pendant sa charge et d'avoir une indication utile pour confirmer la reconnaissance du bon pic recherché, dont le positionnement par rapport à la charge de la batterie se trouve dans une plage relativement restreinte connue. En variante, cette charge pourrait débuter à un état non totalement déchargé de la batterie, mais avec un niveau de charge inférieur à celui du pic (c'est-à-dire sur la gauche du pic recherché sur la figure 3).

D'autre part, cette charge est réalisée à un régime très lent, par exemple de C/25, ce qui engendre des courants très faibles et permet une mesure de tension aux bornes de la batterie formant une pseudo tension à vide. En variante, une relaxation de la batterie est mise en oeuvre avant chaque mesure de tension. De plus, cette mesure de tension à vide et de mesure et/ou estimation de la dérivée de la tension à vide est réalisée périodiquement, selon une période prédéfinie au préalable de manière compatible avec la détection du pic recherché.

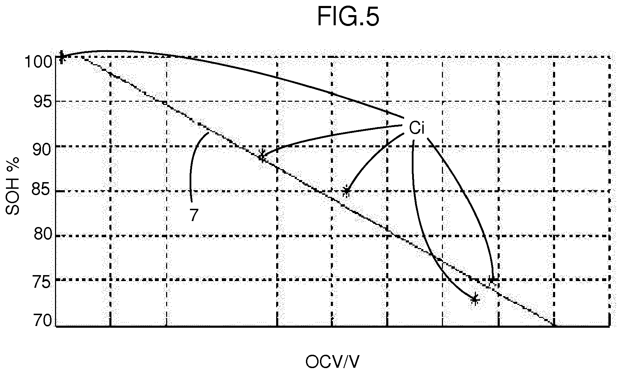

Finalement, plusieurs couples de valeurs réelles (OCVi, SOHi) sont ainsi obtenus par le procédé de calibration, pour chaque valeur d'état de santé SOH de la batterie pour laquelle les étapes précédentes E4 à E7 sont mises en oeuvre. A titre d'exemple, ces couples de valeurs réelles sont illustrés par des points Ci sur le graphe de la figure 5.

Ensuite, le procédé de calibration selon ce mode de réalisation comprend une autre étape d'élaboration d'une loi E8 entre le SOH et l'OCV de la batterie à l'état de référence, pour obtenir une estimation future de l'état de santé SOH de la batterie pour toute valeur de tension à vide OCV, à partir des quelques valeurs discrètes, représentées par les points Ci, réellement mesurées. Dans l'exemple choisi, la figure 5 montre, par le tracé de la droite 7, une relation linéaire entre le SOH et l'OCV à l'état de référence de la batterie. Les paramètres permettant de caractériser cette droite, ou plus généralement la loi déterminée à partir des points réels Ci, par exemple établie par tout procédé d'interpolation mathématique, peuvent aussi être mémorisés avec les données de calibration. En remarque, cette étape E8 peut en variante être réalisée ultérieurement, lors de l'utilisation de la batterie par exemple, non nécessairement pendant la phase de calibration.

D'autres paramètres, comme ceux permettant de caractériser la charge de la batterie mise en oeuvre dans la phase de calibration, peuvent aussi être mémorisés comme des données de référence, car le procédé sera mis en oeuvre en utilisant de préférence les mêmes conditions de charge, pour lesquelles les données de référence sont les plus pertinentes. Toutefois, il n'est pas obligatoire de reproduire les mêmes conditions de charge que celles de la calibration, les données de calibration restent exploitables avec toute autre condition de charge.

En complément, la méthode choisie pour le calcul de la tension à vide de la batterie est aussi mémorisée, afin de toujours reproduire le même calcul, comme cela a été explicité précédemment. De plus, la fréquence optimale des mesures d'OCV pendant la charge peut aussi être mémorisée, pour son éventuelle utilisation lors de l'estimation future, et garantir la bonne détection du pic de la dérivée de la tension à vide. Enfin, le positionnement approximatif de ce pic peut aussi être mémorisé, par exemple à l'intérieur d'une plage de valeurs de charge de la batterie.

Naturellement, cette phase de calibration P1 peut être réalisée une seule fois (sur une seule batterie) pour une certaine famille de batteries, voire plusieurs fois, notamment sur plusieurs batteries, pour établir une moyenne qu'on espère plus précise, les résultats s'appliquant alors par la suite à toutes les batteries de la famille fonctionnant selon cette même technologie, lors de leur utilisation dans un système.

De plus, cette phase de calibration peut être réalisée pour un nombre de valeurs de SOH de la batterie prédéterminé, qui représente un compromis entre la précision obtenue, d'autant plus élevée que le nombre de SOH est élevé, et la simplicité de la phase de calibration, d'autant plus simple et rapide que le nombre de SOH est bas. Par la suite, si on souhaite une grande précision, il est possible d'augmenter le nombre de valeurs de SOH réels considérés. Avantageusement, au moins deux points sont calibrés (ce qui peut notamment être suffisant si la loi est sensiblement linéaire), et de préférence au moins trois, c'est-à-dire que le nombre de SOH distincts est supérieur ou égal à 3. Parmi les SOH considérés, on peut avantageusement intégrer l'état neuf de la batterie et au moins un état vieilli. En complément, pour augmenter la précision du procédé, il est aussi possible de mémoriser des données de calibration pour plusieurs états de référence d'une même batterie, par exemple répartis autour d'un même pic et/ou associés à des pics différents.

Le procédé a été décrit en mentionnant des périodes de charge de la batterie. En variante, les mêmes étapes pourraient être mises en oeuvre en utilisant des périodes de décharge. Les deux approches, charge et décharge, peuvent être cumulées et/ou combinées lors de la calibration pour offrir plus de précision et souplesse par la suite.

De plus, le procédé a utilisé la variation de la tension à vide OCV de la batterie en fonction de la charge de la batterie Qc mais en variante, il pourrait reposer de manière similaire sur la variation de la tension à vide OCV en fonction du temps et la dérivée de la tension à vide par rapport au temps. Dans ce dernier cas, il est alors préférable de travailler à régime constant ou en prenant le soin de filtrer le signal de tension (filtre passBas).

Le procédé a aussi négligé la température. Toutefois, si une définition de pseudo OCV assez éloignée de la tension à vide théorique est choisie, il peut être utile de considérer la température comme variable du procédé, et mettre en oeuvre le même procédé de calibration pour plusieurs températures différentes.

Le procédé est applicable à une seule batterie, c'est-à-dire une batterie élémentaire se présentant sous la forme d'une partie active de stockage, par exemple basée sur des composants chimiques ou de nature capacitive, disposée dans un boîtier dont une première face externe forme la borne positive ou premier collecteur de courant de la batterie et une seconde face externe forme la borne négative ou second collecteur de courant. Ce boîtier a pour fonction le maintien et support de la partie active de la batterie, et son étanchéité vis-à-vis de l'extérieur. Il enferme un assemblage physique qui forme un ensemble monolithique figé, indissociable, dont la connectique électrique est non modifiable pour un utilisateur de la batterie élémentaire, qui voit un courant sortant égal au courant entrant sur ses deux bornes.

En variante, le procédé est applicable à un assemblage électrique de plusieurs batteries élémentaires, de préférence présentant peu de dispersions et de déséquilibres entre elles, et notamment à un pack batterie, comprenant un assemblage électrique en série de plusieurs modules comprenant des batteries élémentaires en parallèles et/ou en série.

Selon le mode de réalisation, lorsque la phase de calibration a été établie, une fois pour toute, le procédé peut se servir des données de calibration qui en résultent pour estimer le SOH de toute batterie du même type, durant toute la durée de vie de la batterie, pendant son utilisation. Si nécessaire, la phase de calibration pourrait être recommencée, par exemple en cas de doute sur la qualité des données de calibration, mais cela n'est pas nécessaire pour la mise en oeuvre du procédé d'estimation du SOH qui va être décrit ci-dessous.

Ainsi, le procédé met ensuite en oeuvre un procédé d'estimation du SOH d'une batterie par une seconde phase P2 d'estimation du SOH pendant son utilisation normale.

Cette seconde phase P2 consiste à déduire l'état de santé d'une batterie des données de calibration, dès lors que la batterie se trouve à l'état de référence, à partir de la mesure ou estimation de sa tension à vide dans cet état de référence.

Cette seconde phase P2 comprend les étapes préalables suivantes, en vue de déclencher cette seconde phase P2, selon le mode de réalisation :
- Une étape de détection E12 automatique de la situation électrique de la batterie pour détecter qu'elle se trouve à proximité de l'état de référence, par exemple à partir de la connaissance de son état de charge ou de sa tension à vide ; ou en variante
- Une étape de modification E13 de la configuration de la batterie (charge ou décharge) pour la positionner à proximité de l'état de référence.

Une autre étape préalable de déclenchement E11 de la seconde phase P2 peut reposer sur l'une des étapes suivantes :
- E11a : Commande de déclenchement suite à une demande d'un utilisateur par l'intermédiaire d'une interface homme machine du dispositif dans lequel la batterie est utilisée ou d'un dispositif de charge de la batterie ;
- E11b : Déclenchement automatique selon une fréquence prédéfinie ;
- E11c: Déclenchement automatique lorsque les conditions électriques de la batterie sont favorables, c'est-à-dire qu'elle se trouve à proximité de l'état de référence ;
- E11d : déclenchement automatique lors d'une phase de charge d'une batterie (cette phase de charge étant déclenchée de manière indépendante, par exemple parce que la batterie est fortement déchargée).

Les étapes E11 et E12 ou E13 peuvent éventuellement être cumulées.

Ensuite, le procédé met en oeuvre une étape E14 qui repose ensuite sur une période de charge, ou en variante de décharge, de la batterie, durant laquelle la tension à vide est mesurée ou estimée et/ou la dérivée de la tension à vide mesurée ou estimée. Cette étape n'est pas obligatoirement réalisée dans les mêmes conditions que celle de la phase de calibration, notamment les conditions de charge peuvent ici être nominales.

Ensuite, le procédé met en oeuvre une étape de détection E15 d'un pic de la dérivée de la tension à vide de la batterie, une étape de positionnement E16 de la batterie à son état de référence, et de mesure de la tension à vide à l'état de référence, puis une étape de déduction E17 de son état de santé à partir des données de calibration et de la tension à vide mesurée. Ces étapes ne sont pas détaillées car elles sont similaires à celles explicitées pour la calibration.

Naturellement, le procédé peut comprendre une dernière étape E19 de transmission de cette estimation du SOH à un opérateur, par l'intermédiaire d'une interface homme machine d'un dispositif d'estimation du SOH.

Le procédé précédent a été décrit sur la base de l'approche la plus répandue pour définir l'état de santé d'une batterie, qui consiste à considérer la perte en capacité de stockage d'une quantité de charges. En variante, le même procédé peut être adapté pour l'estimation de l'état de santé d'une batterie selon une autre approche, par exemple en considérant sa perte en possibilité de restitution d'énergie avec le temps. Dans une telle approche, l'adaptation de ce procédé peut être obtenue en remplaçant les quantités de charges par des quantités d'énergie.

De plus, l'invention peut être mise en oeuvre avec différents types de batterie. Elle est particulièrement adaptée aux batteries Lithium ION à base de manganèse ou de tout type de technologie présentant un comportement similaire du point de vue de l'invention.

Comme cela a été mentionné précédemment, les courbes illustrées ont été obtenues lors d'une phase de charge d'une batterie. Inversement, on constate le même phénomène lors d'une phase de décharge. Ainsi, le mode de réalisation pourrait inversement être implémenté en considérant une phase de décharge.

On pourrait aussi considérer en variante la dérivée de la tension à vide par le temps, notamment dans le cas d'une charge ou décharge à régime constant.

Finalement, le mode de réalisation de l'invention présente les avantages suivants :
- Il présente l'avantage de ne pas nécessiter une pleine charge ou décharge de la batterie mais de pouvoir procéder à l'estimation de son état de santé de manière non intrusive, pendant l'utilisation de la batterie, lorsqu'elle passe par son état intermédiaire de référence, facile à identifier ;
- Les calculs mis en oeuvre dans la seconde phase P2 sont simples, ce qui permet leur mise en oeuvre sans nécessiter une puissance de calcul élevée, et donc compatible avec une implémentation au sein de tout dispositif, comme un objet portable éventuellement de petite taille ;
- L'approche est facilement généralisable à tout type de batteries, il suffit de reproduire la phase de calibration au moins une fois pour chaque type de batteries ;
- Le procédé montre en pratique qu'il permet d'atteindre une très grande précision ;
- Le procédé permet une mise en oeuvre rapide, ce qui le rend non intrusif, car il peut facilement être mis en oeuvre de manière opportuniste, lorsque la batterie est proche de son état de référence, sans déranger le fonctionnement normal de la batterie.

L'invention porte aussi sur un dispositif d'estimation de l'état de santé d'une batterie comprenant une unité de gestion mettant en oeuvre le procédé d'estimation de l'état de santé (SOH) de la batterie tel que décrit précédemment, par des composants matériel et/ou logiciel. Pour cela, l'unité de gestion comprend un calculateur, est associée à au moins une mémoire électronique stockant notamment les données numériques issues de la première phase de calibration, c'est-à-dire les données de calibration, et un logiciel de calcul mettant en oeuvre tout ou partie du procédé d'estimation de l'état de santé (SOH). L'invention porte d'ailleurs aussi sur un tel logiciel en tant que tel. Le dispositif comprend aussi une interface homme machine permettant d'informer un utilisateur de l'état de santé de la batterie, et d'interagir avec lui pour définir certains paramètres du procédé, par exemple les conditions de déclenchement de l'estimation. Enfin, le dispositif comprend au moins un capteur de mesure de tension et/ou de courant et/ou de température relié(s) par un moyen de communication à l'unité de gestion. En remarque, le dispositif de gestion de la batterie, qui met en oeuvre le procédé d'estimation de son état de santé, peut être intégré à la batterie elle-même.

L'invention porte aussi sur un dispositif équipé d'une batterie, qui comprend un tel dispositif d'estimation de l'état de santé de la batterie.

L'invention porte aussi sur un dispositif de calibration de batterie, qui permet la mise en oeuvre des étapes de détection d'un pic de la dérivée de la tension à vide. Ce dispositif comprend donc aussi un calculateur et une mémoire électronique recevant les données de calibration et autres données à mémoriser, pour leur exploitation future par un dispositif d'estimation. Ce dispositif de calibration peut aussi comprendre un composant mettant en oeuvre des cycles de charges et décharges d'une batterie, pour la positionner dans un état de santé choisi.

A titre d'exemple non limitatif, le procédé d'estimation peut ainsi être intégré au sein d'un véhicule automobile, notamment un véhicule électrique ou hybride, et il peut être mis en oeuvre pendant le fonctionnement normal du véhicule automobile. Il peut aussi être implémenté dans un chargeur de batteries ou plus spécifiquement dans une borne de recharge de véhicules. Il peut aussi être implémenté au sein de tout objet portable, comme un ordinateur portable, une tablette, un téléphone portable, un agenda électronique, etc.).

## Revendications

1. Procédé de calibration d'une batterie permettant de mémoriser des données de calibration liées à son état de santé, comprenant les étapes suivantes :
E1 : détermination d'au moins un état caractéristique de la batterie, intermédiaire entre sa pleine charge et sa pleine décharge, par la détection d'un pic de l'évolution de la dérivée de sa tension à vide pendant une charge ou une décharge de la batterie, ou d'au moins un état caractéristique à sa pleine charge ou sa pleine décharge, ou défini par le passage d'un seuil de tension, respectivement de courant, lors d'une phase de courant imposé, respectivement de tension imposée, pendant une charge ou une décharge de la batterie ;
E2 : définition d'un état de référence de la batterie à partir de cet état caractéristique ;
Le procédé est **caractérisé par** les étapes suivantes:
E4-E7 : mesure des tensions à vide OCVi de la batterie à l'état de référence pour plusieurs états de santé SOHi distincts et mémorisation de ces données de calibration comprenant au moins des couples de valeurs réelles état de santé/tension à vide SOHi/OCVi dans une mémoire électronique.

2. Procédé de calibration d'une batterie selon la revendication précédente, **caractérisé en ce que** l'étape de détermination d'au moins un état caractéristique de la batterie prend en compte la dérivée de sa tension à vide par rapport à la quantité de charge accumulée par la batterie ou par rapport au temps.

3. Procédé de calibration d'une batterie selon l'une des revendications précédentes, **caractérisé en ce que** l'état de référence est choisi dans une zone stabilisée de la dérivée de la tension à vide à proximité du pic de l'état caractéristique détecté.

4. Procédé de calibration d'une batterie selon la revendication précédente, **caractérisé en ce que** l'état de référence est défini par un décalage d'une charge fixe Q1 de la charge accumulée par la batterie par rapport à sa charge au niveau du pic détecté.

5. Procédé de calibration d'une batterie selon l'une des revendications précédentes, **caractérisé en ce qu'**il comprend la répétition des étapes suivantes pour plusieurs états de santé distincts d'au moins une batterie :
E4 : positionnement d'une batterie dans un état de santé SOHi choisi et connu ;
E5 : charge ou décharge de la batterie, mesure et/ou estimation de la dérivée de la tension à vide de la batterie et détection du pic prédéfini de la dérivée ;
E6 : poursuite de la charge ou décharge d'une quantité de charge prédéfinie à partir du pic prédéfini pour atteindre l'état de référence de la batterie, et mesure de sa tension à vide OCVi dans cet état de référence ;
E7 : mémorisation dans une mémoire électronique comprenant les données de calibration du couple de valeurs comprenant la valeur de l'état de santé SOHi et la tension à vide OCVi associée à l'état de référence de la batterie.

6. Procédé de calibration d'une batterie selon l'une des revendications précédentes, **caractérisé en ce qu'**il met en oeuvre des phases de charge ou décharge lentes de la batterie pour faciliter la mesure de la tension à vide.

7. Procédé de calibration d'une batterie selon l'une des revendications précédentes, **caractérisé en ce que** la tension à vide de la batterie est obtenue par l'une des étapes suivantes :
- Mesure de la tension aux bornes de la batterie non reliée à une charge après un temps de relaxation supérieur à une heure ; ou
- Mesure de la tension aux bornes de la batterie non reliée à une charge après un temps de relaxation inférieur ou égal à une heure ; ou
- Mesure de la tension aux bornes de la batterie malgré un très faible courant, émis ou reçu par la batterie ; ou
- Mesure de la tension aux bornes de la batterie dans des conditions différentes de la tension à vide théorique et mise en oeuvre d'une correction de la tension mesurée pour estimer la tension à vide ;
- Estimation de la tension à vide de la batterie à partir d'une ou plusieurs grandeur(s) électrique(s) mesurée(s) de la batterie.

8. Procédé de calibration d'une batterie selon l'une des revendications précédentes, **caractérisé en ce qu'**il comprend une étape E8 de détermination d'une loi entre l'état de santé de la batterie et sa tension à vide dans l'état de référence, notamment par interpolation linéaire et/ou la construction d'un abaque associant une valeur d'état de santé de la batterie à une valeur de tension à vide de la batterie à un état de référence, à partir des couples de valeurs réelles état de santé/tension à vide SOHi/OCVi.

9. Procédé de calibration d'une batterie selon l'une des revendications précédentes, **caractérisé en ce qu'**il est mis en oeuvre à partir d'au moins une batterie de la famille de batteries à l'état neuf, et à partir de la même batterie dans au moins un état de vieillissement.

10. Procédé d'estimation de l'état de santé d'une batterie, **caractérisé en ce qu'**il comprend une phase de calibration P1 mettant en oeuvre un procédé de calibration selon l'une des revendications précédentes, et une phase d'estimation P2 de l'état de santé de la batterie comprenant la mesure de sa tension à vide dans l'état de référence et la déduction de l'estimation de son état de santé à partir des données de calibration obtenues dans la phase de calibration P1 et de la tension à vide mesurée.

11. Procédé d'estimation de l'état de santé d'une batterie selon la revendication précédente, **caractérisé en ce que** la seconde phase d'estimation P2 comprend tout ou partie des étapes préalables suivantes, en vue de déterminer son déclenchement :
- E11a: Commande de déclenchement suite à une demande d'un utilisateur par l'intermédiaire d'une interface homme machine d'un dispositif dans lequel la batterie est utilisée ou d'un dispositif de charge de la batterie ; et/ou
- E11b: Déclenchement automatique selon une fréquence prédéfinie ; et/ou
- E11c: Déclenchement automatique lorsque les conditions électriques de la batterie sont favorables ;
- E11d: déclenchement automatique lors d'une phase de charge d'une batterie ;
ET / OU **en ce qu'**elle comprend les étapes préalables suivantes :
- Une étape de détection E12 automatique de la situation électrique de la batterie pour détecter l'état caractéristique; ou
- Une étape de modification E13 de la configuration de la batterie pour la positionner à proximité de l'état de référence.

12. Procédé d'estimation de l'état de santé d'une batterie selon la revendication 10 ou 11, **caractérisé en ce qu'**il met en oeuvre les étapes suivantes :
E14 - mesure ou estimation de la dérivée de la tension à vide pendant une charge ou décharge de la batterie,
E15 - détection d'un pic de cette dérivée de la tension à vide,
E16 - positionnement de la batterie à son état de référence à partir du pic de la dérivée de la tension à vide, et mesure de la tension à vide de la batterie,
E17 - déduction de l'état de santé de la batterie à partir des données de calibration et de la tension à vide mesurée.

13. Support informatique lisible par une unité de gestion, **caractérisé en ce qu'**il comprend un programme informatique enregistré comprenant des moyens de codes de programme informatique de mise en oeuvre du procédé d'estimation de l'état de santé d'une batterie selon l'une des revendications 10 à 12.

14. Dispositif comprenant au moins une batterie et une unité de gestion, **caractérisé en ce que** l'unité de gestion met en oeuvre un procédé d'estimation de l'état de santé d'au moins une batterie selon l'une des revendications 10 à 12.

15. Dispositif selon la revendication précédente, **caractérisé en ce qu'**il est un véhicule automobile ou un objet portable comme un ordinateur, un téléphone, une tablette ou un agenda électronique.

16. Dispositif de calibration d'une batterie, **caractérisé en ce qu'**il met en oeuvre un procédé de calibration selon l'une des revendications 1 à 9.

## Patentansprüche

1. Verfahren zur Kalibrierung einer Batterie, das es ermöglicht, Kalibrierungsdaten in Zusammenhang mit ihrem Intaktheitsstatus zu speichern, umfassend die folgenden Schritte:
E1: Bestimmung mindestens eines charakteristischen Status der Batterie zwischen ihrer vollen Ladung und ihrer vollen Entladung durch Erfassung eines Peaks der Entwicklung der Ableitung ihrer Ruhespannung während einer Ladung oder einer Entladung der Batterie oder zumindest eines charakteristischen Status für ihre volle Ladung oder ihre volle Entladung, oder definiert durch das Passieren einer Spannungs- bzw. Stromgrenze während einer Fremdstrom- bzw. Fremdspannungsphase während einer Ladung oder einer Entladung der Batterie;
E2: Definition eines Referenzstatus der Batterie auf Basis dieses charakteristischen Status;
wobei das Verfahren durch die folgenden Schritte gekennzeichnet ist:
E4-E7: Messung der Ruhespannungen OCVi der Batterie im Referenzstatus für mehrere unterschiedliche Intaktheitsstatus SOHi und Speicherung dieser Kalibrierungsdaten, umfassend mindestens reale Wertepaare Intaktheitsstatus/Ruhespannung SOHi/OCVi, in einem elektronischen Speicher.

2. Verfahren zur Kalibrierung einer Batterie nach dem vorhergehenden Anspruch, **dadurch gekennzeichnet, dass** der Schritt der Bestimmung mindestens eines charakteristischen Status der Batterie die Ableitung ihrer Ruhespannung bezogen auf die von der Batterie angehäufte Lademenge oder bezogen auf die Zeit berücksichtigt.

3. Verfahren zur Kalibrierung einer Batterie nach einem der vorhergehenden Ansprüche, **dadurch gekennzeichnet, dass** der Referenzstatus in einer stabilisierten Zone der Ableitung der Ruhespannung in der Nähe des Peaks des erfassten charakteristischen Status ausgewählt wird.

4. Verfahren zur Kalibrierung einer Batterie nach dem vorhergehenden Anspruch, **dadurch gekennzeichnet, dass** der Referenzstatus durch eine Abweichung einer fixen Ladung Q1 der von der Batterie angehäuften Ladung in Bezug zu ihrer Ladung im Bereich des erfassten Peaks definiert ist.

5. Verfahren zur Kalibrierung einer Batterie nach einem der vorhergehenden Ansprüche, **dadurch gekennzeichnet, dass** es die Wiederholung der folgenden Schritte für mehrere unterschiedliche Intaktheitsstatus mindestens einer Batterie umfasst:
E4: Positionierung einer Batterie in einem gewählten und bekannten Intaktheitsstatus SOHi;
E5: Ladung oder Entladung der Batterie, Messung und/oder Schätzung der Ableitung der Ruhespannung der Batterie und Erfassung des vordefinierten Peaks der Ableitung;
E6: Fortsetzung der Ladung oder Entladung einer vordefinierten Lademenge auf Basis des vordefinierten Peaks, um den Referenzstatus der Batterie zu erreichen, und Messung ihrer Ruhespannung OCVi in diesem Referenzstatus;
E7: Speicherung in einem elektronischen Speicher, umfassend die Kalibrierungsdaten des Wertepaars, umfassend den Wert des Intaktheitsstatus SOHi und die Ruhespannung OCVi, die dem Referenzstatus der Batterie zugeordnet ist.

6. Verfahren zur Kalibrierung einer Batterie nach einem der vorhergehenden Ansprüche, **dadurch gekennzeichnet, dass** es langsame Ladungs- oder Entladungsphasen der Batterie einsetzt, um die Messung der Ruhespannung zu erleichtern.

7. Verfahren zur Kalibrierung einer Batterie nach einem der vorhergehenden Ansprüche, **dadurch gekennzeichnet, dass** die Ruhespannung der Batterie durch einen der folgenden Schritte erhalten wird:
- Messung der Spannung an den Klemmen der Batterie, die nicht an eine Ladung angeschlossen ist, nach einer Relaxationszeit von mehr als einer Stunde; oder
- Messung der Spannung an den Klemmen der Batterie, die nicht an eine Ladung angeschlossen ist, nach einer Relaxationszeit von weniger als oder gleich einer Stunde; oder
- Messung der Spannung an den Klemmen der Batterie trotz eines sehr geringen Stroms, der von der Batterie entsandt oder empfangen wird; oder
- Messung der Spannung an den Klemmen der Batterie unter verschiedenen Bedingungen der theoretischen Ruhespannung und Einsatz einer Korrektur der gemessenen Spannung, um die Ruhespannung zu schätzen;
- Schätzung der Ruhespannung der Batterie auf Basis einer oder mehrerer gemessener elektrischer Größen der Batterie.

8. Verfahren zur Kalibrierung einer Batterie nach einem der vorhergehenden Ansprüche, **dadurch gekennzeichnet, dass** es einen Schritt E8 der Bestimmung eines Gesetzes zwischen dem Intaktheitsstatus der Batterie und ihrer Ruhespannung im Referenzstatus umfasst, insbesondere durch lineare Interpolation und/oder Erstellung eines Abakus, der einen Wert eines Intaktheitsstatus der Batterie einem Ruhespannungswert der Batterie in einem Referenzstatus auf Basis der realen Wertepaare Intaktheitsstatus/Ruhespannung SOHi/OCVi zuordnet.

9. Verfahren zur Kalibrierung einer Batterie nach einem der vorhergehenden Ansprüche, **dadurch gekennzeichnet, dass** es auf Basis mindestens einer Batterie der Familie von Batterien im Neuzustand und auf Basis derselben Batterie in mindestens einem Alterungszustand eingesetzt wird.

10. Verfahren zur Schätzung des Intaktheitsstatus einer Batterie, **dadurch gekennzeichnet, dass** es eine Kalibrierungsphase P1, die ein Kalibrierungsverfahren nach einem der vorhergehenden Ansprüche einsetzt, und eine Phase der Schätzung P2 des Intaktheitsstatus der Batterie umfasst, umfassend die Messung ihrer Ruhespannung im Referenzstatus und die Ableitung der Schätzung ihres Intaktheitsstatus aus den in der Kalibrierungsphase P1 erhaltenen Kalibrierungsdaten und der gemessenen Ruhespannung.

11. Verfahren zur Schätzung des Intaktheitsstatus einer Batterie nach dem vorhergehenden Anspruch, **dadurch gekennzeichnet, dass** die zweite Schätzungsphase P2 alle oder einen Teil der folgenden vorhergehenden Schritte umfasst, um seine Auslösung zu bestimmen:
- Ella: Steuerung einer Auslösung nach einem Antrag eines Benutzers mit Hilfe einer Mensch-Maschine-Schnittstelle einer Vorrichtung, in der die Batterie verwendet wird, oder einer Ladevorrichtung der Batterie; und/oder
- E11b: automatische Auslösung nach einer vordefinierten Frequenz; und/oder
- E11c: automatische Auslösung, wenn die elektrischen Bedingungen der Batterie günstig sind;
- E11d: automatische Auslösung während einer Ladephase einer Batterie;
UND/ODER dass es die folgenden vorhergehenden Schritte umfasst:
- einen Schritt der automatischen Erfassung E12 der elektrischen Situation der Batterie, um den charakteristischen Status zu erfassen; oder
- einen Schritt der Änderung E13 der Konfiguration der Batterie, um sie in der Nähe des Referenzstatus zu positionieren.

12. Verfahren zur Schätzung des Intaktheitsstatus einer Batterie nach Anspruch 10 oder 11, **dadurch gekennzeichnet, dass** es die folgenden Schritte einsetzt:
E14 - Messung oder Schätzung der Ableitung der Ruhespannung während einer Ladung oder Entladung der Batterie,
E15 - Erfassung eines Peaks dieser Ableitung der Ruhespannung,
E16 - Positionierung der Batterie in ihrem Referenzstatus auf Basis des Peaks der Ableitung der Ruhespannung und Messung der Ruhespannung der Batterie,
E17 - Ableitung des Intaktheitsstatus der Batterie aus den Kalibrierungsdaten und der gemessenen Ruhespannung.

13. Informatikträger, der von einer Verwaltungseinheit lesbar ist, **dadurch gekennzeichnet, dass** er ein registriertes Informatikprogramm umfasst, umfassend Informatikprogrammcodemittel für den Einsatz des Verfahrens zur Schätzung des Intaktheitsstatus einer Batterie nach einem der Ansprüche 10 bis 12.

14. Vorrichtung, umfassend mindestens eine Batterie und eine Verwaltungseinheit, **dadurch gekennzeichnet, dass** die Verwaltungseinheit ein Verfahren zur Schätzung des Intaktheitsstatus mindestens einer Batterie nach einem der Ansprüche 10 bis 12 einsetzt.

15. Vorrichtung nach dem vorhergehenden Anspruch, **dadurch gekennzeichnet, dass** sie ein Kraftfahrzeug oder ein tragbarer Gegenstand, wie ein Computer, ein Telefon, ein Tablet oder eine elektronische Agenda ist.

16. Vorrichtung zur Kalibrierung einer Batterie, **dadurch gekennzeichnet, dass** sie ein Kalibrierungsverfahren nach einem der Ansprüche 1 bis 9 einsetzt.

## Claims

1. A method for calibrating a battery allowing calibration data linked to its state of health to be memorized, comprising the following steps:
E1: determining at least one characteristic state of the battery, intermediate between fully charged and fully discharged, by detecting a peak in the variation of the derivative of its open-circuit voltage while charging or discharging the battery, or at least one characteristic state when it is fully charged or fully discharged, or defined by the crossing of a voltage, or current, threshold, in a constant current, or constant voltage, phase while charging or discharging the battery;
E2: defining a reference state of the battery on the basis of this characteristic state;
the method is **characterized by** the following steps:
E4-E7: measuring the open-circuit voltages OCVi of the battery in the reference state for multiple different states of health SOHi and memorizing these calibration data comprising at least some pairs of actual state of health/open-circuit voltage SOHi, OCVi values in an electronic memory.

2. The method for calibrating a battery as claimed in the preceding claim, **characterized in that** the step of determining at least one characteristic state of the battery takes into account the derivative of its open-circuit voltage with respect to the quantity of charge accumulated by the battery or with respect to time.

3. The method for calibrating a battery as claimed in one of the preceding claims, **characterized in that** the reference state is chosen in a stabilized area of the derivative of the open-circuit voltage in proximity to the peak of the detected characteristic state.

4. The method for calibrating a battery as claimed in the preceding claim, **characterized in that** the reference state is defined by a shift by a fixed charge Q1 in the charge accumulated by the battery with respect to its charge at the detected peak.

5. The method for calibrating a battery as claimed in one of the preceding claims, **characterized in that** it comprises the repetition of the following steps for multiple different states of health of at least one battery:
E4: placing a battery in a known and chosen state of health SOHi;
E5: charging or discharging the battery, measuring and/or estimating the derivative of the open-circuit voltage of the battery and detecting the predefined peak in the derivative;
E6: continuing to charge or discharge a predefined quantity of charge on the basis of the predefined peak in order to attain the reference state of the battery, and measuring its open-circuit voltage OCVi in this reference state;
E7: memorizing, in an electronic memory comprising the calibration data, the pair of values comprising the value of the state of health SOHi and the open-circuit voltage OCVi associated with the reference state of the battery.

6. The method for calibrating a battery as claimed in one of the preceding claims, **characterized in that** it implements phases of slow charging or discharging of the battery in order to facilitate the measurement of the open-circuit voltage.

7. The method for calibrating a battery as claimed in one of the preceding claims, **characterized in that** the open-circuit voltage of the battery is obtained via one of the following steps:
- measuring the voltage across the terminals of the battery when not connected to a load after a relaxation time of more than one hour; or
- measuring the voltage across the terminals of the battery when not connected to a load after a relaxation time of less than or equal to one hour; or
- measuring the voltage across the terminals of the battery despite a very weak current delivered or received by the battery; or
- measuring the voltage across the terminals of the battery under different conditions of the theoretical open-circuit voltage and implementing a correction for the measured voltage in order to estimate the open-circuit voltage;
- estimating the open-circuit voltage of the battery on the basis of one or more measured electrical quantities of the battery.

8. The method for calibrating a battery as claimed in one of the preceding claims, **characterized in that** it comprises a step E8 of determining a law between the state of health of the battery and its open-circuit voltage in the reference state, in particular through linear interpolation and/or the construction of a chart associating a value of the state of health of the battery with a value of the open-circuit voltage of the battery in a reference state, on the basis of the pairs of actual state of health/open-circuit voltage SOHi, OCVi values.

9. The method for calibrating a battery as claimed in one of the preceding claims, **characterized in that** it is implemented using at least one battery of the family of batteries in the new state, and using the same battery in at least one aged state.

10. A method for estimating the state of health of a battery, **characterized in that** it comprises a calibration phase P1 implementing a calibration method as claimed in one of the preceding claims, and an estimation phase P2 the state of health of the battery comprising the measurement of its open-circuit voltage in the reference state and deducing the estimation of its state of health from the calibration data obtained in the calibration phase P1 and from the measured open-circuit voltage.

11. The method for estimating the state of health of a battery as claimed in the preceding claim, **characterized in that** the second estimation phase P2 comprises all or some of the following preliminary steps, for the purpose of determining the triggering thereof:
- E11a : trigger command subsequent to a request from a user via a human-machine interface of a device in which the battery is used or of a battery charging device; and/or
- E11b : automatic triggering at a predefined frequency; and/or
- E11c : automatic triggering when the electrical conditions of the battery are favorable;
- E11d : automatic triggering in one phase of charging a battery;
AND/OR **in that** it comprises the following preliminary steps:
- a step E12 of automatically detecting the electrical situation of the battery in order to detect the characteristic state; or
- a step E13 of modifying the configuration of the battery in order to place it in proximity to the reference state.

12. The method for estimating the state of health of a battery as claimed in claim 10 or 11, **characterized in that** it implements the following steps:
E14 - measuring or estimating the derivative of the open-circuit voltage while charging or discharging the battery;
E15 - detecting a peak in this derivative of the open-circuit voltage;
E16 - placing the battery in its reference state on the basis of the peak in the derivative of the open-circuit voltage, and measuring the open-circuit voltage of the battery;
E17 - deducing the state of health of the battery from the calibration data and from the measured open-circuit voltage.

13. A computer medium readable by a management unit, **characterized in that** it comprises a recorded computer program comprising computer program code means for implementing the method for estimating the state of health of a battery as claimed in one of claims 10 to 12.

14. A device comprising at least one battery and one management unit, **characterized in that** the management unit implements a method for estimating the state of health of at least one battery as claimed in one of claims 10 to 12.

15. The device as claimed in the preceding claim, **characterized in that** it is an automotive vehicle or a mobile object such as a computer, a telephone, a tablet or a personal digital assistant.

16. A device for calibrating a battery, **characterized in that** it implements a calibration method as claimed in one of claims 1 to 9.
